Europäisches Patentamt

European Patent Office

Office européen des brevets

(11) Veröffentlichungsnummer: **0 370 196 B1**

(19)

(12) **EUROPÄISCHE PATENTSCHRIFT**

(45) Veröffentlichungstag der Patentschrift: **24.11.93**

(21) Anmeldenummer: **89117574.7**

(22) Anmeldetag: **22.09.89**

(51) Int. Cl.5: **H01J 37/073**, G01R 31/28

(54) Verfahren zum Betrieb eines Elektronenstrahlmessgerätes.

(30) Priorität: **24.11.88 DE 3839707**

(43) Veröffentlichungstag der Anmeldung:
**30.05.90 Patentblatt 90/22**

(45) Bekanntmachung des Hinweises auf die
Patenterteilung:
**24.11.93 Patentblatt 93/47**

(84) Benannte Vertragsstaaten:
**DE FR GB IT NL**

(56) Entgegenhaltungen:
**FR-A- 1 596 753**
**FR-A- 2 076 604**
**US-A- 4 868 380**

**NUCLEAR INSTRUMENTS AND METHODS.**
**vol. A264, no. 2-3, 15 Februar 1988, AMSTER-**
**DAM NL Seiten 131 - 134; Boussoukaya et al.:**
**"Pulsed photocurrents from lanthanum hex-**
**aboride cathodes on the ns regime"**

(73) Patentinhaber: **ICT Integrated Circuit Testing**
**Gesellschaft für Halbleiterprüftechnik mbH**
**Klausnerring 1a**
**D-85551 Kirchheim(DE)**

(72) Erfinder: **Feuerbaum, Hans-Peter, Dr.**
**Arno-Assmann-Strasse 14**
**D-8000 München 83(DE)**
Erfinder: **Frosien, Jürgen, Dr.**
**An der Ottosäule 18**
**D-8012 Ottobrunn(DE)**

(74) Vertreter: **Tetzner, Volkmar, Dr.-Ing. Dr. jur.**
**Van-Gogh-Strasse 3**
**D-81479 München (DE)**

EP 0 370 196 B1

**Beschreibung**

Die Erfindung bezieht sich auf ein Verfahren zum Betrieb eines Elektronenstrahlmeßgerätes.

Aus Appl. Phys. Lett. 51 (2), 1987, Seite 145 bis 147 ist ein Elektronenstrahlmeßgerät bekann, dessen termische LaB6- bzw. Feldemissionsquelle durch eine mit einem gepulsten Laserstrahl (Impulswiederholfrequenz $\gamma$ = 100 MHz, Impulsbreite $\approx$ 1 bis 2 ps) beaufschlagte Photokathode ersetzt wurde. Da die Breite der erzeugten Photoelektronenimpulse etwa der Breite der Laserimpulse entspricht, ist dieses Gerät insbesondere für stroboskopische Messungen in schnellen Gallium-Arsenid-Schaltungen geeignet. Der apparative Aufwand zur Erzeugung der Photoelektronenimpulse ist allerdings beträchtlich. So ist eine zweimalige Frequenzverdoppelung des primären Laserlichtes ($\lambda$ = 1064 nm) notwendig, um Photoelektronen aus der als Kathode dienenden Goldschicht (Elektronenaustrittsarbeit W = 4,5 eV) auszulösen.

Aus dem J. Phys. E: Sci. Instrum 20 (1987), Seiten 1491 bis 1493 ist ein Rasterelektronenmikroskop bekannt, dessen Wolframkathode mit Hilfe eines gepulsten Laserstrahls innerhalb weniger Nanosekunden auf Temperaturen oberhalb des Schmelzpunktes aufgeheizt und dadurch zur thermischen Emission von Elektronen angeregt wird. Auch in diesem Gerät ist eine Frequenzverdoppelung der in einem Nd-YAG-Laser erzeugten Primärstrahlung notwendig. Außerdem entsteht bei höheren Laserenergien ein zweiter Elektronenimpuls, der mit Hilfe eines Ablenksystems ausgeblendet werden muß. Zudem ist die Lebensdauer der Kathode in Folge der hohen Abdampfrate des Kathodenmaterials begrenzt.

Der Erfindung liegt die Aufgabe zugrunde, ein Verfahren zum Betrieb eines Elektronenstrahlmeßgerätes anzugeben, mit dem Photoelektronenimpulse ohne eine Frequenzverdoppelung des primären Laserlichtes erzeugt werden können. Außerdem soll der Sondenstrom deutlich erhöht werden. Diese Aufgabe wird erfindungsgemäß durch Verfahren nach den Patentansprüchen 1 und 2 gelöst.

Der mit der Erfindung erzielbare Vorteil besteht insbesondere darin, daß man konventionelle Laserquellen zur Erzeugung der Photoelektronenimpulse verwenden kann.

Die Unteransprüche betreffen vorteilhafte Weiterbildungen und Ausgestaltungen der Erfindung, die im folgenden anhand der Zeichnung näher erläutert wird. Hierbei zeigt:

Fig. 1      ein Elektronenstrahlmeßgerät
Fig. 2 und 3      Elektronenstrahlerzeuger
Fig. 4      ein Element einer Multipoloptik zur Korrektur des Öffnungs- und/oder Farbfehlers einer Objektivlinse.

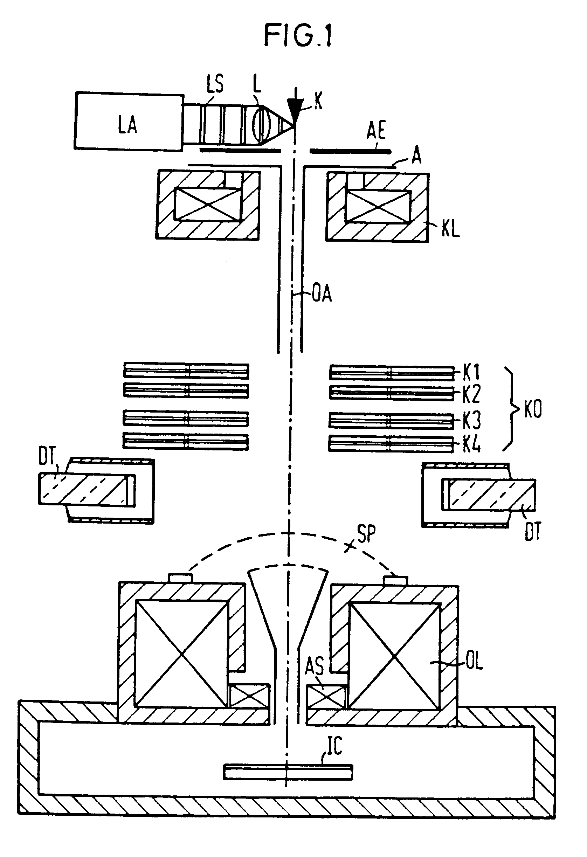

Das in Fig. 1 schematisch dargestellte Elektronenstrahlmeßgerät umfaßt einen aus einer Feldemissionskathode K, einer Extraktionselektrode AE und einer Anode A bestehenden Strahlerzeuger, eine Laserquelle LA, insbesondere einen Nd: YAG-Laser, eine Optik L zur Fokussierung der impulsförmig emittierten Laserstrahlung LS ($\lambda$ = 1064 nm, Impulswiederholrate $\gamma$ = 100 MHz) auf die Kathodenspitze, eine Kondensorlinse KL, einen aus mindestens vier Acht- oder Zwölfpolelementen K1 bis K4 bestehenden Korrektor KO und eine Objektivlinse, die ein von der Kondensorlinse KL erzeugtes Zwischenbild der Photoelektronenquelle verkleinert auf das in der evakuierten Probenkammer angeordnete Bauelement IC abbildet. Die Objektivlinse, mit der man sowohl die Photoelektronen als auch die an einer Meßstelle ausgelösten Sekundärelektronen in jeweils einen auf der optischen Achse OA liegenden Punkt fokussiert, besteht im wesentlichen aus einer kurzbrennweitigen Magnetlinse OL, einer Ablenkeinheit AS und einem Sekundärelektronspekrometer SP zur Bestimmung des Meßpunktpotentials. Der Fokus der im Feld einer Absaugelektrode beschleunigten Sekundärelektronen liegt hierbei im Zentrum eines kugelsymetrischen elektrischen Gegenfeldes, das sich in dem oberhalb des Linsenkörpers angeordneten Spektrometerteil zwischen zwei annähernd halbkugelförmigen Elektroden aufbaut. Sekundärelektronen mit Energien oberhalb einer durch das Spektrometerfeld definierten Mindestenergie werden in zwei symmetrisch zur Strahlachse OA angeordneten Detektoren DT nachgewiesen.

Da die Photonenenergie $E_{Ph}$ = 1.17 eV ($\lambda$ = 1064 nm) nicht ausreicht, Elektronen aus der Wolframkathode K (Spitenradius $r_0$ = 0,1 bis 0,5 $\mu$m, Austrittsarbeit W $\approx$ 4,5 eV) auszulösen, wird die Potentialbarriere an der Grenzfläche Metall-Vakuum und damit die Austrittsarbeit erfindungsgemäß mit einem äußeren elektrischen Feld soweit reduziert, daß die Bedingung

$$W_{eff} \leq E_{Ph}$$

$W_{eff}$ : = Austrittsarbeit mit äußerem Feld
$E_{Ph}$ : = Photoenergie

erfüllt ist. Das äußere Feld erzeugt man mit Hilfe der gegenüber der Kathode K positiv geladenen Extraktionselektrode AE. Deren Potential wird so vorgegeben, daß Photoemission, aber noch keine Feldemission einsetzt ("feldunterstützte Photoemission"). Die Feldstärke im Bereich der Kathodenspitze darf deshalb den für die Feldemission kritischen Wert von etwa $10^6$ bis $10^7$ V/cm nicht überschreiten. Im übrigen wird das Extraktionspotential durch die Photonenergie, d. h. die Art des verwendeten Lasers LA, und die geometrischen Verhältnisse innerhalb des Strahlerzeugers (Spitzenradius der Kathode, Abstand Kathode K - Extraktionselektrode AE) bestimmt. Um die auf Erdpotential liegenden Probe IC mit Elektronen der Energie $E_{PE}$ = 1 keV zu bestrahlen, kann man die Kathode K beispielsweise mit einem Potential $U_K$ = -1 kV, die Extraktionselektrode AE mit einem Potential $U_{AE}$ = 0,5 bis 6 kV und die Anode A mit einem Potential $U_A$ = 0 kV beaufschlagen. Es ist selbstverständlich auch möglich, die Photoelektronen zuerst auf eine hohe Energie von beispielsweise $E_{PE}$ = 10 keV ($U_A$ = 9 kV) zu beschleunigen, um sie dann unterhalb des Strahlerzeugers mit Hilfe einer Zusatzelektrode oder einem Immersionskondensor auf die gewünschte Endenergie abzubremsen.

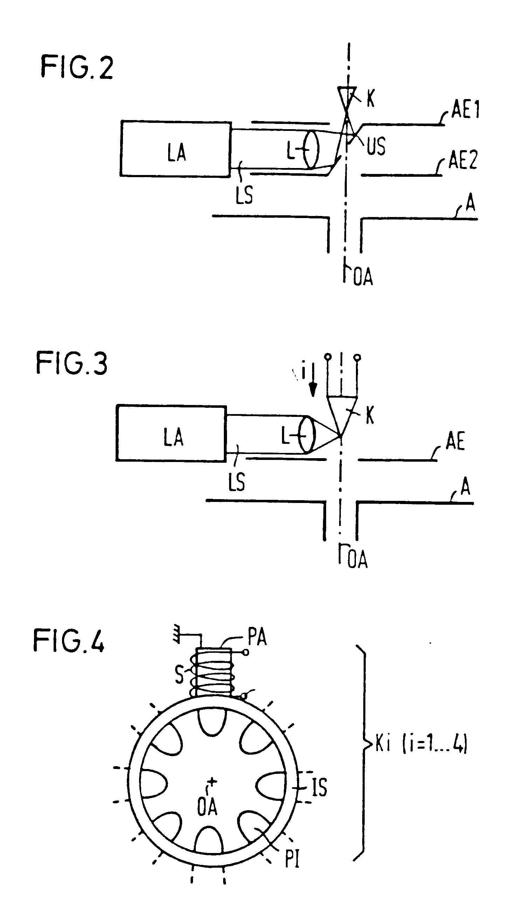

Bei dem in Fig. 2 dargestellten Strahlerzeuger wird das Laserlicht LS mit Hilfe einer Linse L und eines ebenen oder parabolischen Spiegels US auf die Kathodenspitze fokussiert. Der mit einer Ausnehmung zum Durchtritt der Photoelektronen versehene Spiegel US ist hierbei zwischen zwei auf demselben Potential $U_{AE}$ liegenden Extraktionselektroden AE1 bzw. AE2 angeordnet. Dieser Strahlerzeuger hat gegenüber dem in Fig. 1 dargestellten System den Vorteil, daß die Photoelektronen vorwiegend in Richtung der optischen Achse OA des Elektronenstrahlmeßgerätes emittiert werden.

Fig. 3 zeigt einen Strahlerzeuger, in dem die Kathode K mit Hilfe eines Heizstromes i auf eine Temperatur gebracht wird, bei der Photoemission, aber noch keine thermische Emission einsetzt ("thermisch unterstützte Photoemission"). Der Heizstrom i ist deshalb so einzustellen, daß die Kathodentemperatur unterhalb des für thermische Emission kritischen Wertes von etwa 2000 K bleibt. Die Photoemission kann auch hierbei wieder durch ein von der Extraktionselektrode AE erzeuges elektrisches Feld unterstützt werden. Es ist selbstverständlich auch möglich, das Laserlicht LS mit Hilfe der in Fig. 2 dargestellten Optik L/US auf die Kathode K zu fokussieren.

Zur Erhöhung des Sondenstromes ist das Elektronenstrahlmeßgerät mit einem aus mindestens vier Acht- oder Zwölfpolelementen K1 bis K4 bestehenden Korrektor KO ausgestattet. Diese aus Optik 34, Heft 3 (1971) Seiten 285 bis 311 (s. insbesondere Seite 3 und 8, Fig. 9) und den Proceedings zum 9. Internatinal Congress on Electron Microscopy, Toronto 1978, Vol. 3, Seite 186 bis 196 bekannte Multipoloptik dient der Korrektur des axialen Farb- und/oder axialen Öffnungsfehlers der Objektivlinse, so daß man bei gleicher Auflösung wesentlich größere Aperturen $\alpha$ zulassen kann. Da der Sondenstrom $i_{PE}$ dem Quadrat der Objektivlinsenapertur $\alpha$ proportional ist, die bei Verwendung eines Korrektors KO um etwa einen Faktor 10 vergrößert werden kann, erhöht der Sondenstrom $i_{PE}$ sich gemäß der Beziehung $i_{PE} \sim \alpha^2$ um einen Faktor 100.

Ein Element Ki (i = 1 bis 4) des vorzugsweise unmittelbar oberhalb der Objektivlinse angeordneten Korrektors KO ist schematisch in Fig. 4 dargestellt. Es besteht aus acht auf dem Potential $U_A$ der Anode A liegenden inneren Polschuhen PI, die durch einen zylinderförmigen Isolator IS von den auf Masse bzw. Erdpotential liegenden und mit jeweils einer Erregerspule S umgebenen äußeren Polschuhen PA getrennt sind. In jedem der Elemente Ki werden magnetische Quadrupol- und Oktupolfelder zur Korrektur des Öffnungsfehlers der Objektivlinse erzeugt. Zur Korrektur des Farbfehlers werden elektrische Quadrupolfelder aufgebaut, indem man die inneren Elektroden PI der beiden mittleren Multipolelemente K2 und K3 des Korrektors KO mit entsprechenden Zusatzpotentialen beaufschlagt.

Vier Acht- oder Zwölfpolelemente Ki reichen aus, um den axialen Öffnungs- und Farbfehler der Objektivlinse zu korrigieren. Die Verwendung von fünf Elementen bietet allerdings zusätzlich die Möglichkeit auch die außeraxialen Linsenfehler zu reduzieren. Mit der Korrektur des Öffnungsfehlers dritter Ordnung begrenzen die mit dem Abstand zwischen Korrektor KO und Objektivlinse ML anwachsenden Öffnungsfehler fünfter Ordnung die Auflösung. Auch deren Einfluß kann durch Verwendung zwölfpoliger Elemente erheblich reduziert werden, ohne die Korrekturen niedrigerer Ordnung zu beeinträchtigen.

Die Erfindung ist selbstverständlich nicht auf die beschriebenen Ausführungsbeispiele beschränkt. So kann das Verfahren insbesondere auch in einem Raster-Elektronenmikroskop angewendet werden.

**Patentansprüche**

1. Verfahren zum Betrieb eines Elektronenstrahlmeßgerätes, das eine mit einem Photonenstrahl (LS) beaufschlagte Kathode (K), eine Anode (A) zur Beschleunigung der auf der Kathode (K) ausgelösten Elektronen in Richtung einer optischen Achse (OA), eine Objektivlinse (ML) und einen Detektor (DT) zum Nachweis der auf einer Probe (IC) ausgelösten Sekundärteilchen aufweist, **dadurch gekennzeichnet,** daß die Kathode (K) mit Photonen bestrahlt wird, deren Energie kleiner ist als die Elektronenaustrittsarbeit des Kathodenmaterials und daß die Austrittsarbeit mit Hilfe eines äußeren elektrischen Feldes soweit reduziert wird, daß Photoemission, aber noch keine Feldemission einsetzt.

2. Verfahren zum Betrieb eines Elektronestrahlmeßgeräts, das eine mit einem Photonenstrahl (LS) beaufschlagte Kathode (K), eine Anode (A) zur Beschleunigung der auf der Kathode (K) ausgelösten Elektronen in Richtung einer optischen Achse (OA), eine Objektivlinse (ML) und einen Detektor (DT) zum Nachweis der auf einer Probe (IC) ausgelösten Sekundärteilchen aufweist,
**dadurch gekennzeichnet,** daß die Kathode (K) mit Photonen bestrahlt wird, deren Energie kleiner ist als die Elektronenaustrittarbeit des Kathodenmaterials und daß die Kathode (K) soweit aufgeheizt wird, daß Photoemission, aber noch keine thermische Emission einsetzt.

3. Verfahren nach Anspruch 1 oder 2,
**dadurch gekennzeichnet,** daß eine die Photonen emittierende Quelle (LA) gepulst betrieben wird.

4. Verfahren nach einem der Ansprüche 1 bis 3,
**dadurch gekennzeichnet,** daß die Photonen in Richtung der optischen Achse (OA) auf die Kathode (K) eingestrahlt werden.

5. Verfahren nach einem der Ansprüche 1 bis 4,
**dadurch gekennzeichnet,** daß die Photonen mit Hilfe eines Spiegels (US) in Richtung der optischen Achse (OA) und der Kathode (K) umgelenkt werden.

6. Verfahren nach Anspruch 5,
**dadurch gekennzeichnet,** daß der mit einer Ausnehmung versehene Spiegel (US) im Strahlengang zwischen einer ersten und einer zweiten Extraktionselektrode (AE1, AE2) angeordnet wird.

7. Verfahren nach einem der Ansprüche 1 bis 6,
**dadurch gekennzeichnet,** daß eine als Spitze ausgebildete Kathode (K) verwendet wird.

8. Verfahren nach einem der Ansprüche 1 bis 7,
**dadurch gekennzeichnet,** daß der axiale Farb- und/oder axiale Öffnungsfehler der Objektivlinse (ML) mit Hilfe einer Multipoloptik (KO) korrigiert wird.

9. Verfahren nach Anspruch 8,
**dadurch gekennzeichnet,** daß eine aus mindestens vier Acht- oder Zwölfpolelementen (K1, K2, K3, K4) bestehende Multipoloptik (KO) verwendet wird.

## Claims

1. Method of operating an electron beam measuring device which has a cathode (K) acted upon by a photon beam (LS), an anode (A) for accelerating the electrons released on the cathode (K) in the direction of an optical axis (OA), an objective lens (ML) and a detector (DT) to detect the secondary particles released on a sample (IC), characterised in that the cathode (K) is irradiated with photons, the energy level of which is lower than the electron work function of the cathode material, and the work function is reduced with the aid of an external electrical field to such an extent that photoemission occurs, but not field emission.

2. Method of operating an electron beam measuring device which has a cathode (K) acted upon by a photon beam (LS), an anode (A) for accelerating the electrons released on the cathode (K) in the direction of an optical axis (OA), an objective lens (ML) and a detector (DT) to detect the secondary particles released on a sample (IC), characterised in that the cathode (K) is irradiated with photons, the energy level of which is lower than the electron work function of the cathode material, and the cathode (K) is heated to such an extent that photoemission occurs, but no thermal emission.

3. Method as claimed in claims 1 or 2, characterised in that a source (LA) which emits photons is operated in pulsed mode.

4. Method as claimed in one of claims 1 to 3, characterised in that the photons are irradiated onto the cathode (K) in the direction of the optical axis (OA).

5. Method as claimed in one of claims 1 to 4, characterised in that the photons are deflected in the direction of the optical axis (OA) and of the cathode (K) with the aid of a mirror (US).

6. Method as claimed in claim 5, characterised in that the mirror (US) which is provided with a recess is arranged in the beam path between a first and a second extraction electrode (AE1, AE2).

7. Method as claimed in claims 1 to 6, characterised in that a cathode (K) constructed as a tip is used.

8. Method as claimed in one of claims 1 to 7, characterised in that the axial chromatic aberration and/or the axial spherical aberration of the objective lens (ML) is corrected with the aid of a multipole optical system (KO).

9. Method as claimed in claim 8, characterised in that a multipole optical system (KO) which consists of at least four eight-pole or twelve-pole elements (K1, K2, K3, K4) is used.

**Revendications**

1. Procédé d'exploitation d'un appareil de mesure à faisceau d'électrons, qui comprend une cathode (K) recevant un faisceau de photons (LS), une anode (A) d'accélération des électrodes détachées de la cathode (K) dans la direction d'un axe optique (OA), une lentille d'objectif (ML) et un détecteur (DT) destiné à déceler les particules secondaires détachées d'un échantillon (IC), caractérisé en ce que la cathode (K) est irradiée par des photons dont l'énergie est plus faible que le travail de sortie des électrons de la matière de la cathode et en ce que le travail de sortie est suffisamment réduit à l'aide d'un champ électrique extérieur pour qu'il se produise une photoémission, mais pas encore une émission de champ.

2. Procédé d'exploitation d'un appareil de mesure à faisceau d'électrons qui comprend une cathode (K) recevant un faisceau de photons (LS), une anode (A) d'accélération des électrons détachés sur la cathode (K) dans la direction d'un axe optique (OA), une lentille d'objectif (ML) et un détecteur (DT) destiné à déceler les particules secondaires détachées sur une échantillon (IC), caractérisé en ce que la cathode (K) est irradiée par des photons dont l'énergie est plus faible que le travail de sortie des électrons de la matière de la cathode et en ce que la cathode (K) est suffisamment chauffée pour qu'il se produise une photoémission, mais pas encore une émission thermique.

3. Procédé selon la revendication 1 ou 2, caractérisé en ce qu'une source (LA) d'émission de photons est pulsée.

4. Procédé selon l'une des revendications 1 à 3, caractérisé en ce que les photons sont dirigés en un faisceau sur la cathode (K) dans la direction de l'axe optique (OA).

5. Procédé selon l'une des revendications 1 à 4, caractérisé en ce que les photons sont déviés à l'aide d'un miroir (US) en direction de l'axe optique (OA) et de la cathode (K).

6. Procédé selon la revendication 5, caractérisé en ce que le miroir (US), qui comporte un trou, est disposé sur la marche du faisceau entre une première et une seconde électrode d'extraction (AE1, AE2).

7. Procédé selon l'une des revendications 1 à 6, caractérisé en ce que la cathode (K) utilisée est conformée en pointe.

8. Procédé selon l'une des revendications 1 à 7, caractérisé en ce que l'aberration chromatique axiale et/ou l'aberration axiale d'ouverture de la lentille de l'objectif (ML) est corrigée à l'aide d'une optique multipolaire (KO).

9. Procédé selon la revendication 8, caractérisé en ce que l'optique multipolaire utilisée (KO) se compose d'au moins quatre éléments (K1, K2, K3, K4) à huit ou douze pôles.

# FIG.1

FIG.2

FIG.3

FIG.4